# EUROPÄISCHE PATENTSCHRIFT

(11) **EP 0 876 195 B1**
(45) Veröffentlichungstag und Bekanntmachung des Hinweises auf die Patenterteilung: **06.03.2002**
(21) Anmeldenummer: 97906988.7
(22) Anmeldetag: 09.01.1997
(51) Int. Cl.: B01D 61/00, H05K 3/00, G03F 7/30, G03F 7/42

(54) **VERFAHREN ZUM AUFTRENNEN VON AUS DER LEITERPLATTENHERSTELLUNG STAMMENDEN ORGANISCHEN PROZESSLÖSUNGEN**
METHOD OF FILTERING THE ORGANIC SOLUTIONS ARISING IN THE PRODUCTION OF CIRCUIT BOARDS
PROCEDE DE FILTRATION DES SOLUTIONS ORGANIQUES RESULTANT DE LA FABRICATION DES PLAQUETTES DE CIRCUITS IMPRIMES

(30) Priorität: 12.01.1996 DE 19600967
(43) Veröffentlichungstag der Anmeldung: 11.11.1998
(73) Patentinhaber: Vantico AG, 4057 Basel (CH)
(72) Erfinder: GOTTWALD, Thomas, D-78713 Schramberg-Sulgen (DE)
(86) Internationale Anmeldenummer: DE9700022
(87) Internationale Veröffentlichungsnummer: WO9725127

(56) Entgegenhaltungen:
- EP-A- 0 532 199
- EP-A- 0 608 700
- DE-A- 3 143 106
- DE-U- 29 517 588
- GB-A- 2 051 664
- US-A- 4 786 417
- US-A- 4 788 043
- PATENT ABSTRACTS OF JAPAN vol. 006, no. 044 (C-095), 19.März 1982 & JP 56 161803 A (NITTO ELECTRIC IND CO LTD), 12.Dezember 1981, & DATABASE WPI Section Ch, Week 8204 Derwent Publications Ltd., London, GB; Class A31, AN 82-06853e & CHEMICAL ABSTRACTS, vol. 96, no. 20, 17.Mai 1982 Columbus, Ohio, US; abstract no. 164887,
- MULDER M.: "Basic Principles of Membrane Technology" 1990 , KLUWER , DORDRECHT, NL XP002031442 siehe Seite 212, Zeile 12 - Zeile 15
- PATENT ABSTRACTS OF JAPAN vol. 008, no. 232 (C-248), 25.Oktober 1984 & JP 59 115795 A (SANYO KOKUSAKU PULP KK), 4.Juli 1984, & DATABASE WPI Section Ch, Week 8509 Derwent Publications Ltd., London, GB; Class D15, AN 85-051869

## Beschreibung

Die vorliegende Erfindung betrifft ein Verfahren zum Auftrennen von aus der Leiterplattenherstellung stammenden organischen Prozeßlösungen gemäß dem Oberbegriff des Patentanspruchs 1.

Bei vielen Herstellungs- und Verarbeitungsprozessen fallen Lösungen an, welche einerseits wegen ihrer Zusammensetzung bzw. ihrer Toxizität nicht direkt in die Kanalisation geleitet werden können, und andererseits wertvolle Stoffe enthalten, deren Zurückgewinnung bzw. Wiederver-wertung von wirtschaftlichem Interesse ist. So fallen beispielsweise in der fotoverarbeitenden Industrie ständig chemikalienhaltige Behandlungs- und Waschlösungen an, welche vor einer Entsorgung oder Wiederverwertung aufbereitet werden müssen.

So beschreibt die DE-OS-42 36 713 ein Trennverfahren von in einer Flüssigkeit gelösten Bestandteilen, um ein schwach beladenes Abwasser bzw. eine Flüssigkeit mit niedrigen Anteilen an gelösten Bestandteilen zu reinigen, bzw. um die gelösten Chemikalien und auch das Lösungsmittel in eine wiederverwertbare Form zu bringen. Dazu werden in einer Abtrenn- bzw. einer Reinigungsstufe alternativ zwei Membranfilter verwendet, wobei der erste Membranfilter geeignet ist, die gelösten Bestandteile bei hohem Durchsatz und niedriger Konzentration abzutrennen und der zweite Membranfilter für einen niedrigen Durchsatz und eine hohe Konzentration ausgelegt ist. Mit diesem Verfahren werden Fotochemikalien aus Abwässern von einem fotochemischen Behandlungsbad abgetrennt und aufbereitet.

Auch in anderen Bereichen werden Filtrationsverfahren zur Trennung, Konzentrierung und/oder Reinigung von Gemischen eingesetzt.

So beschreibt z.B. der Artikel "Baustein der Weisen" in: Oberfläche + JOT 1979, Heft 7, Seiten 355 - 360, verschiedene Einsatzbereiche der Ultrafiltration, deren Einsatz schwerpunktmäßig bei der Trennung von Öl/Wasser-Emulsionen liegt und bis zur Kreislaufführung von Entfettungsbädern mit dem Ziel der Wasser- und Chemikalienrückgewinnung reicht.

Weiterhin beschreibt die EP-A-0 521 369 eine Vorrichtung und ein Verfahren zum Aufbereiten von Motorkühlmitteln auf Glykolbasis, das eine Umkehrosmose verwendet, um beispielsweise Ethylenglykol aus einer konzentrierten Motorkühlmittellösung abzutrennen.

Die EP 0 608 700 A1 offenbart ein Verfahren zum Auftrennen von aus der Leiterplattenherstellung stammenden organischen Prozesslösungen, wobei man eine erste Trennung durchführt, und das Permeat der ersten Trennung einer zweiten Trennschicht unterwirft.

Ferner beschreibt das Patent Abstract of Japan mit der Veröffentlichungsnummer 56161803 die Behandlung einer harzhaltigen organischen Lösung mit einer selektiven permeablen Membran, die gegenüber organischen Lösungsmitteln beständig ist, um das Harz undenaturiert anzukonzentrieren.

Die EP 0 532 199 A1 beschreibt die Abtrennung von gelösten Substanzen aus N-Methylpyrrolidon mittels spezieller Composite-Membranen, welche auf Silikonbasis hergestellt werden.

In dem Bereich der Leiterplatten herstellenden Industrie oder der Halbleiterindustrie, wo oft auch aggressive organische Lösungsmittel verwendet werden, ist bisher kein derartiges Verfahren bekannt. Aber auch hier fallen in hohem Maße Lösungen und vor allem organische Lösungen an, die entweder entsorgt oder zur Wiederverwertung aufgearbeitet werden müssen.

Bisher wurde die Trennung solcher Prozeßmedien bzw. Prozeßlösungen durch Destillation bei hohen Temperaturen und unter Unterdruck durch geführt. Dazu ist allerdings viel Energie und ein hoher apparativer sowie sicherheitstechnischer Aufwand, insbesondere Explosionsschutzmaßnahmen erforderlich. Bei einem solchen herkömmlichen Verfahren ist der Destillationsrückstand ein Gemisch aus Harzen und Füllstoffen, das entsorgt oder verbrannt werden muß.

Ein alternatives Entsorgungsverfahren ist in der US-PS-4 786 417 beschrieben, wobei eine Lösung, die wasserlösliche Photoresistmaterialien enthält, zunächst einer Ultrafiltration unterworfen wird, das Permeat der Ultrafiltration wiederverwertet wird und das abgetrennte Photoresistmaterial zur einfacheren Entsorgung mittels elektromagnetischer Strahlung polymerisiert wird.

Dieses Verfahren hat ebenfalls den Nachteil, daß dabei nur das Lösungsmittel, welches im vorliegenden Beispielsfalle Wasser ist, wiederverwertet wird, während die gelösten und teilweise wertvollen organischen Substanzen unter relativ großem Aufwand entsorgt werden.

Daher ist es die Aufgabe der vorliegenden Erfindung, speziell für den Bereich der Leiterplattenherstellung ein Verfahren zur Verfügung zu stellen, welches die Auftrennung von Prozeßlösungen sowie eine Wiederverwertung mehrerer Lösungsbestandteile daraus ermöglicht.

Die Lösung dieser Aufgabe erfolgt durch die Merkmale des Patentanspruchs 1.

Mit dem erfindungsgemäßen Verfahren wird eine Auftrennung und Wiederverwendung von einzelnen Bestandteilen von aus der Leiterplattenherstellung stammenden organischen Prozeßlösungen in organisches Prozeßlösungsmittel, Wasser, gelöste Substanzen und nichtgelöste Feststoffe ermöglicht. Dabei wird mittels Ultrafiltration oder Umkehrosmose eine erste Trennung in eine erste Fraktion, welche hauptsächlich das organische Lösungsmittelumfasst, und eine zweite Fraktion, welche die gelösten Substanzen enthält, durchgeführt, und die dabei erhaltene erste Fraktion wird einem Trennschritt mittels Umkehrosmose oder Pervaporation zum Abtrennen von Wasser aus dem zurückgewonnenen Prozesslösungsmittel unterworfen.

Die Auftrennung bei dem erfindungsgemäßen Verfahren führt zu wenigstens zwei Fraktionen, wobei eine Fraktion vorzugsweise hauptsächlich das Lösungsmittel und eine weitere Fraktion hauptsächlich die darin gelösten Substanzen enthält. Nach der Auftrennung können beide Fraktionen wenigstens teilweise wiederverwendet werden.

Somit ermöglicht das erfindungsgemäße Verfahren eine wenigstens teilweise Wiederverwertung des Prozeßlösungsmittels sowie der darin gelösten Substanzen.

Dabei hat das erfindungsgemäße Verfahren den Vorteil, daß nur relativ geringe Investitionskosten anfallen und daß außerdem im Vergleich zu dem früheren Destillationsverfahren eine hohe Energieersparnis erzielt werden kann. Dabei kann die Energieersparnis durch Verringerung des Destillationsaufwandes bis zu über 90 % betragen.

Weiterhin können durch eine Wiederverwertung des Lösungsmittels sowie der darin gelösten Substanzen die für die Leiterplattenherstellung anfallenden Materialkosten deutlich gesenkt werden.

Schließlich wird es durch das erfindungsgemäße Verfahren möglich, die bei der Leiterplattenherstellung anfallenden Abfälle zu verringern oder sogar ganz zu vermeiden, wodurch ebenfalls weitere Kosten für eine ansonsten notwendige, und aufgrund der in der Leiterplattenherstellung verwendeten teilweise aggressiven Lösungsmittel, auch kostenaufwendige Entsorgung eingespart werden können.

Dieser letzte Punkt ist gerade in der heutigen Zeit ein wichtiger Aspekt, wo immer mehr eine möglichst ökologische und umweltschonende Handhabung von Chemikalien angestrebt wird.

Bei dem erfindungsgemäßen Verfahren wird als Feinstfiltration eine Ultrafiltration oder eine Umkehrosmose verwendet. Dabei wird die Auswahl unter diesen Verfahren von den Bestandteilen der jeweils zu trennenden Prozeßlösung abhängen.

Um die Effizienz der Filtration zu erhöhen kann es sinnvoll sein, zunächst eine Abtrennung von möglicherweise in der Prozeßlösung enthaltenen Feststoffen oder Füllstoffen durchzuführen. Eine solche Abtrennung kann durch Filtrationsverfahren, Sedimentationsverfahren, Schrägklärerprinzip, Zentrifugation oder andere Verfahren, insbesondere solche, die auf dem vorhandenen Masseunterschied beruhen, erfolgen.

Weiterhin kann als zusätzlicher Schritt nach der Filtration das eingedickte Retentat, welches die gelösten Substanzen sowie Reste des Lösungsmittels enthält, unter Unterdruck bei niedrigen Temperaturen destilliert werden, um eine weitere Reinigung und eine noch weitergehende Wiederverwertung zu erreichen.

Dabei sollte die Destillationstemperatur unterhalb der für die Härtung kritischen Temperatur- und Zeitkombination liegen, wobei Temperaturen von ca. 120 °C bis ca. 160 °C bevorzugt sind. Davon ist ebenfalls die Höhe des anzuwendenden Unterdruckes abhängig, welcher vorzugsweise bei ca. 90.000 bis ca. 50.000 Pa (ca. 900 bis ca. 500 mbar) liegt.

Außerdem wird ein zusätzlicher Trennungsschritt zum Abtrennen von Wasser aus dem zurückgewonnenen Lösungsmittel vorgesehen werden, welcher als eine Umkehrosmose oder auch als eine Pervaporation durchgeführt wird.

Die zusätzliche Abtrennung von Wasser hat den Vorteil, daß das Lösungsmittel dann im konzentrierten Zustand weiterverwendet werden kann, oder, sollte es als eine Mischung verwendet werden, daß diese mit größerer Genauigkeit eingestellt werden kann.

Außerdem können die verwendeten Lösungsmittel hygroskopisch sein, was dann zu einer weiteren Anreicherung von Wasser führen kann. In einem solchen Fall ist die zusätzliche Abtrennung von Wasser besonders bevorzugt.

Bei der Filtration wird vorteilhaft eine gegen organische Lösungen beständige Membran eingesetzt. Dieses ist vor allem bei aggressiven organischen Lösungen wie z.B. Ethyldiglykol- oder Methylpyrrolidonlösungen notwendig. Weiterhin sollte die Membran eine von dem zu trennenden Prozeßmedium abhängige geeignete Porengröße aufweisen, um dadurch die Trennung von gelösten Substanzen und Lösungsmittel zu optimieren.

Eine solche Membran wird bevorzugt ausgewählt aus der Gruppe bestehend aus: organischen, insbesondere asymmetrischen organischen Polymermembranen, bevorzugt solchen aus Polyvinylidenfluorid (PVDF), Polypropylen (PP), Polytetrafluorethylen (PTFE) und/oder Polyethylen (PE), und anorganischen Membranen, insbesondere Keramik- oder Kohlenstoffmembranen, und mineralisch belegten anorganischen Membranen.

Bei dem erfindungsgemäßen Verfahren besteht weiterhin die vorteilhafte Möglichkeit, eine Kreislaufführung der aufbereiteten Bestandteile der Prozeßlösungen zu realisieren, womit das Aufbereitungsverfahren direkt in das Leiterplattenherstellungsverfahren integriert werden kann.

Als Prozeßlösung werden beispielsweise Ethyldiglykol-Fotostopplack-Lösungen aus der Fotostopplackentwicklung, Butyldiglykol-Fotostopplack-Lösungen aus der Fotostopplackentwicklung, γ-Butyrolacton-Foto-stopplack-Lösungen aus der Fotostopplackentwicklung, N-Methylpyrroli-don-Lack-Lösungen und Gemische aus Stripprozessen sowie sonstige Lösungsmittel-Fotostopplack- oder Lösungsmittel-Resist-Lösungen eingesetzt.

Weiterhin können auch Lösungsmittel aus Reinigungsprozessen aufbereitet werden, bei denen organische Substanzen in Lösungsmitteln gelöst werden, die mit der Herstellung von Leiterplatten nicht unmittelbar in Verbindung stehen.

Das für eine Wiederverwendung vorgesehene organische Lösungsmittel der Prozeßlösung wird vorzugsweise ausgewählt aus der Gruppe bestehend aus: Ethyldiglykol (EDG), Diethylenglykolmonoethylether (Molekulargewicht 134,2 g/mol), Butyldiglykol (BDG), Diethylenglykolmonobutylether (Molekulargewicht 162,23 g/mol), γ-Butyrolacton (GBL), Dihydro-2(3H)-furanon (Molekulargewicht 86,09 g/mol), N-Methylpyrrolidon (NMP, Molekulargewicht 99,1 g/mol), Methoxypropylacetat (MPA), Propylenglykolmethyletheracetat (Molekulargewicht 132 g/mol) und DY 950 (eine Produktbezeichnung von der Ciba-Geigy Ag, Basel, Schweiz, wobei das genannte Produkt γ-Butyrolacton sowie weitere Zusätze enthält) sowie deren Mischungen.

Weitere Vorteile und Merkmale der vorliegenden Erfindung ergeben sich aufgrund der Beschreibung von Ausführungsbeispielen sowie anhand der Zeichnung.

Es zeigt:

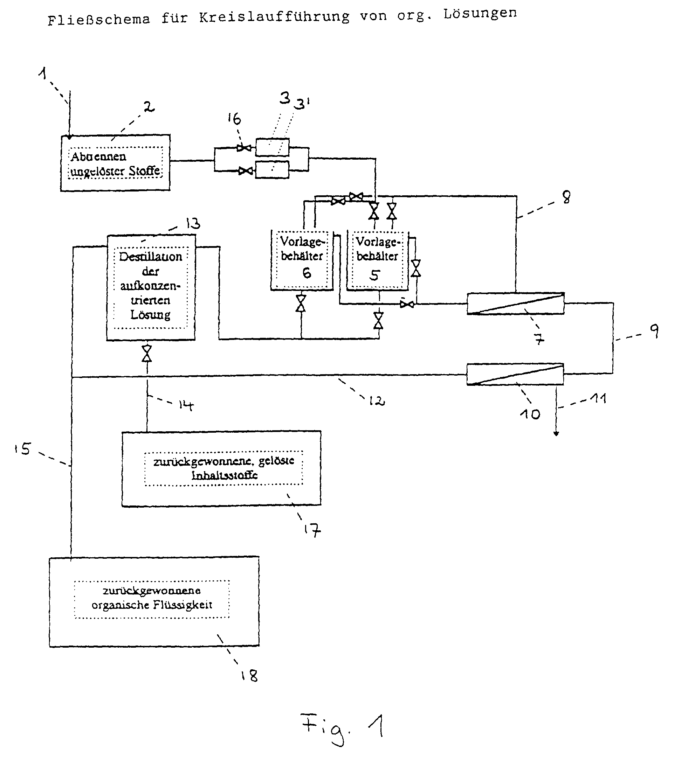

- Fig. 1: eine schematische Darstellung einer Anlage zur Durchführung des erfindungsgemäßen Verfahrens.

Eine Ausführungsform der vorliegenden Erfindung wird nun mit Bezug auf Figur 1 beschrieben.

Die zu trennenden organischen Prozeßlösungen werden über eine Leitung 1 in einem ersten Schritt einer Vorrichtung 2 zum Abtrennen von ungelösten Fest- oder Füllstoffen, im Beispielsfalle einer Sedimentationsvorrichtung zugeführt. Bei der Sedimentation wird der Großteil der ungelösten Stoffe abgetrennt.

Anschließend erfolgt eine Filtration über einen Vorfilter 3, um den verbliebenen Rest an ungelösten Stoffe abzutrennen. Für den Fall, daß der Vorfilter 3 verstopft sein sollte, steht ein zweiter Vorfilter 3' zur Verfügung, welcher wahlweise verwendet werden kann. Dabei erfolgt die Auswahl zwischen den Vorfiltern 3 und 3' durch die Betätigung von entsprechenden Ventilen 16.

Danach gelangt die von Feststoffen befreite Prozeßlösung, welche weiterhin das Lösungsmittel und die darin gelösten Substanzen enthält, in einen von zwei Vorlagebehältern 5 oder 6. Dabei wird die Auswahl zwischen diesen Vorlagebehältern 5 und 6 ebenfalls wieder durch Ventile gesteuert. Aus dem entsprechenden Vorlagebehälter wird die Lösung dann zu einem Ultrafiltrationsmodul 7 geführt, in welchem eine Auftrennung der Lösung durch eine Ultrafiltration stattfindet.

Bei der Ultrafiltration erfolgt eine Auftrennung in ein Permeat, welches das Lösungsmittel umfaßt und über eine Leitung 9 abgeführt wird, sowie ein Retentat, das hauptsächlich die konzentrierten gelösten Substanzen sowie Reste des Lösungsmittels enthält. Dieses Retentat wird dann über eine Leitung 8 in einen der Vorlagebehälter 5 und 6 zurückgeführt.

Anschließend kann das Retentat erneut zu dem Ultrafiltrationsmodul 7 geleitet werden und die Ultrafiltration kann so beliebig oft wiederholt werden.

Es besteht ebenfalls die Möglichkeit, das Retentat vor einer erneuten Ultrafiltration mit neuer Prozeßlösung, welche über den Vorfilter 3 oder 3' in den Vorlagebehälter 5 oder 6 geleitet wird, zu verdünnen.

Nach einer ausreichender Reinigung des Retentats, welches die gelösten Substanzen enthält, wird dieses dann aus dem Vorlagebehälter 5 oder 6 zu einer Destillationsvorrichtung 13 geleitet, wo das verbliebene Lösungsmittel durch Destillation abgetrennt wird und die zurück-gewonnenen gelösten Substanzen erhalten werden. Diese werden über eine Leitung 14 abgeführt und in einem Sammelbehälter 17 gesammelt und stehen so für eine Wiederverwendung zur Verfügung. Alternativ können ebenfalls unterschiedliche Fraktionen der Destillation in verschiedenen Sammelbehältern geleitet werden, so daß auch mehrere gelöste Substanzen voneinander getrennt werden können.

Das nach der Ultrafiltration erhaltene Lösungsmittel-Permeat wird über eine Leitung 9 zu einem Pervaporationsmodul 10 geleitet und dort mittels einer Pervaporation von dem darin enthaltenen Wasser befreit. Das nach der Pervaporation erhaltene hauptsächlich Wasser enthaltende Permeat wird dann über eine Leitung 11 abgeleitet.

Das nach der Pervaporation erhaltene Retentat, welches das vom Wasser befreite Lösungsmittel enthält, wird über eine Leitung 12 zu einer Leitung 15 geleitet, welche in einem Sammelbehälter 18 mündet, worin das zurückgewonnene organische Lösungsmittel zu Wieder-verwendung aufbewahrt wird.

In diesen Sammelbehälter 18 wird ebenfalls - auch über die Leitung 15 - das nach der Destillation in der Destillationsvorrichtung 13 erhaltene reine Lösungsmittel geleitet, wo es zusammen mit dem nach der Pervaporation erhaltenen Lösungsmittel gesammelt wird und einer Wiederverwertung zugeführt werden kann.

Ein konkretes Ausführungsbeispiel wird im folgenden beschrieben:

Bei der Herstellung von Lötstoppabdeckungen werden Leiterplatten vollflächig mit fotostrukturierbarem Lack im Vorhanggießverfahren oder durch Siebdruck beschichtet und getrocknet. Die Strukturierung erfolgt durch partielle UV-Licht-Bestrahlung, wobei die belichteten Bereiche der Beschichtung polymerisieren, während die unbelichteten Bereiche nicht reagieren. Die nichtbelichteten Bereiche der Beschichtung sind im Entwicklungsmedium löslich, während die belichteten Bereiche äußerst schwerlöslich sind und somit den Entwicklungsprozeß unbeschadet überstehen.

In der Entwicklungsanlage wird ein Lösungsmittel mit vorgegebenem Druck und Temperatur auf die Platten gesprüht, wodurch die löslichen Bereiche abgewaschen werden.

In der Entwicklungsmaschine fällt dadurch ein Gemisch aus dem Lösungsmittel - EDG - und Fotostopplack an. Bedingt durch die Hygroskopie des Lösungsmittels reichert sich im EDG ebenfalls Wasser an, das ab einer kritischen Grenze störend wirkt. Der getrocknete Lack, der in das Lösungsmittel gelangt, enthält ein hochmolekulares Epoxidharz, Füllstoffe, wie z.B. Talkum, Bariumsulfat, Reste von Lösungsmitteln wie Metoxypropylacetat und Metoxypropanol, Fotoinitiatoren, Sensibilisatoren, Farbstoffe, thermische Härterkomponenten und andere Substanzen, die größtenteils Herstellergeheimnis sind.

Für das Entwicklungsergebnis ist aber hauptsächlich die Konzentration der Harzkomponente in der Entwicklungslösung maßgeblich.

Der Harzanteil der Lösung, die nach dem Verfahren gemäß dem Stand der Technik zur Destillation gegeben wird, liegt bei ca. 3,5 %. Das heißt, für die Rückgewinnung des Lösungsmittels müssen ca. 95 % des angefallenen Gemisches verdampft werden, um 5 % Verunreinigung zu eliminieren. Dabei liegt der Siedepunkt bei Normaldruck bei über 200°C.

Aufgrund der großen Differenz der Molekulargewichte zwischen Lösungsmittel und Harz ist jedoch auch eine Trennung durch Filtrationsmethoden möglich.

Der Kern des erfindungsgemäßen Verfahrens ist hier ein Ultrafiltrationsmodul, in dem die Auftrennung der beiden organischen Komponenten Harz und Lösungsmittel erfolgt.

Damit dieser Prozeß sicher funktioniert, werden vorher die anfallenden Füllstoffe abgetrennt, da diese sonst die Module blockieren oder zu abrasivem Verschleiß der Module führen könnten. Nach erfolgter Trennung wird dem rückgewonnenen Lösungsmittel noch zumindest teilweise das Wasser entzogen, so daß durch Wasseraufnahme keine Prozeßschwan kungen bei der Wiederverwertung zu erwarten sind.

Die eingedickte Harzlösung, welche einen Harzgehalt von mindestens ca. 30 % aufweist, kann anschließend zur weiteren Eindickung der Destillation unterzogen werden. Nach Aufbereitung des anfallenden Harzes kann dieses normalerweise wiederverwendet werden.

Der energie- und kostenintensive Destillationsprozeß kann mit dieser Maßnahme drastisch reduziert oder sogar vollständig eliminiert werden.

Das erfindungsgemäße Verfahren kann grundsätzlich für alle lösungsmittelentwickelbaren Lacksysteme verwendet werden. In gleicher Weise kann das Verfahren auch für die Regenerierung von Stripplösungen verwendet werden. Diese kommen zum Einsatz, um fehlbelichtete Platten wieder vollständig von Lack zu befreien. Hierbei wird in grundsätzlich ähnlichen Anlagen, jedoch mit anderen Lösungsmitteln, z.B. N-Methylpyrrolidon (NMP) gearbeitet, in denen der belichtete Lack zumindest teilweise löslich ist.

## Patentansprüche

1. Verfahren zum Auftrennen von aus der Leiterplattenherstellung stammenden organischen Prozeßlösungen, welche wenigstens ein organisches Lösungsmittel enthalten, in wenigstens zwei Fraktionen, zur wenigstens teilweisen Wiederverwendung, wobei Lösungen mit ungelösten Feststoffen vor dem Auftrennen von organischen Prozesslösungen eine Abrennung von Feststoffen durchgeführt wird,
**dadurch gekennzeichnet, dass** man mittels Ultrafiltration oder Umkehrosmose eine erste Trennung in eine erste Fraktion, welche hauptsächlich das organische Lösungsmittel umfasst, und eine zweite Fraktion, welche die gelösten Substanzen enthält, durchführt, und die dabei erhaltene erste Fraktion einem Trennungsschritt mittels Umkehrosmose oder Pervaporation zum Abtrennen von Wasser aus dem zurückgewonnenen Prozesslösungsmittel unterwirft.

2. Verfahren nach Anspruch 1, **dadurch gekennzeichnet, daß** es weiterhin einen Schritt zum Destillieren der durch die erste Trennung eingedickten zweiten Fraktion bei vermindertem Druck und niedrigen Temperaturen, vorzugsweise von ca. 120 °C bis ca. 160 °C, beinhaltet.

3. Verfahren nach Anspruch 1, **dadurch gekennzeichnet, daß** bei der ersten Trennung eine gegen die Bestandteile der Prozeßlösungen beständige Membran eingesetzt wird, die ausgewählt wird aus der Gruppe bestehend aus: organischen, insbesondere asymmetrischen organischen Polymer-membranen, bevorzugt solchen aus Polyvinylidenfluorid (PVDF), Polypropylen (PP), Polytetrafluorethylen (PTFE) und/oder Polyethylen (PE), und anorganischen Membranen, insbesondere Keramik- oder Kohlenstoffmembranen, und mineralisch belegten anorganischen Membranen.

4. Verfahren nach einem der Ansprüche 1 bis 3, **dadurch gekennzeichnet, daß** die organischen Prozeßlösungen, in folgende Fraktionen aufgetrennt werden: organisches Lösungsmittel, darin gelöste Substanzen und feste Bestandteile.

5. Verfahren nach einem der Ansprüche 1 bis 4, **dadurch gekennzeichnet, daß** die Fraktionen, insbesondere die Lösungsmittel-fraktion, für eine Kreislaufführung vorgesehen sind.

6. Verfahren nach einem der Ansprüche 1 bis 5, **dadurch gekennzeichnet, daß** die Prozeßlösung ausgewählt wird aus der Gruppe, bestehend aus:
(a) Ethyldiglykol-Fotostopplack-Lösungen aus der Fotostopplack-entwicklung;
(b) Butyldiglykol-Fotostopplack-Lösungen aus der Fotostopplack-entwicklung;
(c) γ-Butyrolacton-Fotostopplack-Lösungen aus der Fotostopplack-entwicklung;
(d) N-Methylpyrrolidon-Lack-Lösungen; und
(e) Gemischen aus Stripprozessen.

7. Verfahren nach einem der Ansprüche 1 bis 6, **dadurch gekennzeichnet, daß** das Lösungsmittel der Prozeßlösung ausgewählt wird aus der Gruppe, bestehend aus:
Ethyldiglykol, Diethylenglykolmonoethylether, Butyldiglykol, Diethylenglykolmonobutylether, γ-Butyrolacton, N-Methylpyrrolidon, Methoxypropylacetat und Propylenglykolmethyletheracetat, sowie deren Mischungen.

## Claims

1. A process for separating an organic circuit board manufacture process solution comprising at least one organic solvent into at least two fractions for at least partial reuse, where an organic process solution comprising undissolved solids is subjected to solids removal before being fractionated,
**characterized in that** a first separation into a first fraction primarily comprising the organic solvent and a second fraction comprising the dissolved substances is carried out and the first fraction so obtained is subjected to a separation step by means of reverse osmosis or pervaporation to remove water from the recovered process solvent.

2. A process according to claim 1, **characterized in that** it further comprises a step of distilling the concentrated second fraction from the first separation at reduced pressure and low temperatures, preferably about 120°C to about 160°C.

3. A process according to claim 1, **characterized in that** the first separation is carried out using a membrane which is resistant to the constituents of the process solution and is selected from the group consisting of organic, especially asymmetrical organic, polymer membranes, preferably those composed of polyvinylidene fluoride (PVDF), polypropylene (PP), polytetrafluoroethylene (PTFE) and/or polyethylene (PE), and inorganic membranes, especially ceramic or carbon membranes, and mineral-coated inorganic membranes.

4. A process according to any one of claims 1 to 3, **characterized in that** the organic process solution is separated into the following fractions: organic solvent, substances dissolved therein and solid constituents.

5. A process according to any one of claims 1 to 4, **characterized in that** the fractions, especially the solvent fraction, are intended for recirculation.

6. A process according to any one of claims 1 to 5, **characterized in that** the process solution is selected from the group consisting of:
(a) ethyldiglycol photoresist solutions from photoresist development;
(b) butyldiglycol photoresist solutions from photoresist development;
(c) γ-butyrolactone photoresist solutions from photoresist development;
(d) N-methylpyrrolidone resist solutions; and
(e) mixtures from stripping processes.

7. A process according to any one of claims 1 to 6, **characterized in that** the solvent of the process solution is selected from the group consisting of:
ethyldiglycol, diethylene glycol monoethyl ether, butyldiglycol, diethylene glycol monobutyl ether, γ-butyrolactone, N-methylpyrrolidone, methoxypropyl acetate and propylene glycol methyl ether acetate, and mixtures thereof.

## Revendications

1. Procédé de séparation de solutions organiques de processus résultant de la fabrication de plaquettes de circuits imprimés, qui contiennent au moins un solvant organique, en au moins deux fractions, pour une réutilisation au moins partielle, dans lequel on effectue une séparation de matières solides de solutions ayant des matières solides non dissoutes avant la séparation de solutions organiques de processus,
**caractérisé en ce qu'**on réalise au moyen d'une ultrafiltration ou d'une osmose inverse une première séparation en une première fraction, qui comprend principalement le solvant organique, et une deuxième fraction, qui contient les substances dissoutes, et on soumet la première fraction obtenue à une étape de séparation au moyen d'une osmose inverse ou d'une pervaporation pour l'extraction de l'eau du milieu de solution de processus récupéré.

2. Procédé selon la revendication 1, **caractérisé en ce qu'**il comprend en outre une étape de distillation de la deuxième fraction épaissie par la première séparation sous pression réduite et à de basses températures, de préférence d'environ 120°C jusqu'à 160°C.

3. Procédé selon la revendication 1, **caractérisé en ce qu'**on utilise pour la première séparation une membrane résistante aux constituants des solutions du processus, qui est choisie dans le groupe constitué de : des membranes polymère organiques, en particulier organiques asymétriques, de préférence celles de polyfluorure de vinylidène (PVDF), polypropylène (PP), polytétrafluoroéthylène (PTFE) et/ou polyéthylène (PE), et des membranes inorganiques, en particulier des membranes de céramique ou de carbone, et des membranes inorganiques revêtues d'un minéral.

4. Procédé selon l'une des revendications 1 à 3, **caractérisé en ce que** les solutions organiques de processus sont séparées en les fractions suivantes : solvant organique, substances dissoutes à l'intérieur et constituants solides.

5. Procédé selon l'une des revendications 1 à 4, caractérisé en ce queles fractions, en particulier la fraction du solvant, sont prévues pour une alimentation en boucle.

6. Procédé selon l'une des revendications 1 à 5, **caractérisé en ce que** la solution de processus est choisie dans le groupe, constitué de :
(a) Solutions de vernis épargne photographique et d'éthylglycol issues du développement du vernis épargne photographique ;
(b) Solutions de vernis épargne photographique et de butylglycol issues du développement du vernis épargne photographique ;
(c) Solutions de vernis épargne photographique et de γ-butyrolactone issues du développement du vernis épargne photographique ;
(d) Solutions de vernis et de N-méthylpyrrolidone ; et
(e) Mélanges issus de processus de décapage.

7. Procédé selon l'une des revendications 1 à 6, **caractérisé en ce que** le solvant de la solution de processus est choisi parmi le groupe constitué de :
l'éthyldiglycol, l'éther monoéthylique de diéthylèneglycol, le butyldiglycol, l'éther monobutylique de diéthylèneglycol, la γ-butyrolactone, la N-méthylpyrrolidone, l'acétate de méthoxypropyle et l'éther méthylique de propylène glycol acétate, ainsi que leurs mélanges.
